# EUROPEAN PATENT APPLICATION

(11) **EP 4 545 677 A1**
(43) Date of publication of application: **30.04.2025**
(21) Application number: 23205695.2
(22) Date of filing: 25.10.2023
(51) Int. Cl.: C23C 14/24, C23C 14/54, C23C 14/56, B01B 1/00

(54) **EVAPORATOR FOR COATING SUBSTRATES**

(71) Applicant: NEOVAC GmbH, 63791 Karlstein (DE)
(72) Inventor: ENGLERT, Ulrich, 63791 Karlstein (DE); HERZOG, André, 63791 Karlstein (DE)
(74) Representative: Weilnau, Carsten

(57) **Abstract**

The present disclosure relates to an evaporator (10) for use inside an evaporation chamber (8) and configured to evaporate an evaporation material (12), the evaporator (10) comprising:
- an evaporation crucible (20) comprising an evaporation cavity (19) to contain evaporation material (14),
- an outlet arrangement (24) in flow connection with the evaporation cavity (19) and comprising an evaporation aperture (26) for evaporated evaporation material (14) to flow from the evaporation cavity (19) into the evaporation chamber (8), wherein the aperture (26) comprises a flow-through cross-section of variable and/or adjustable size.

## Description

The present invention relates to the field of coating substrates, and in particular to the field of coating metallic substrates with a metallic coating or anti-corrosive coating. In further aspects the present invention relates to an evaporator, a coating arrangement and a method of continuously coating a movable substrate inside an evaporation or vacuum chamber.

### Background

Coating materials, such as a gaseous metal or metallic layers may be coated on a surface of a metallic substrate, such as a single sheet or steel strip. Here, the substrate is arranged in a coating- or vacuum atmosphere. In vacuum deposition there may be applied various deposition methods, by way of which a solid or liquid coating material, e.g. a metallic coating material, is evaporated. This typically implies a heating of the evaporation material up to an evaporation temperature, e.g. in a vacuum atmosphere, to transition into a gaseous or evaporated state. Once the evaporation material is sufficiently evaporated a thin-film is formed on the substrate as a coating.

Typically and for physical vapor deposition (PVD) of substrates on a rather large scale it is quite challenging to control a deposition rate of an evaporator located inside the vacuum atmosphere. It is also quite challenging to control a geometric expansion of evaporated material inside an evaporation or vacuum chamber. Typically, vapor deposition equipment is designed for a predefined or fixed width of a substrate as seen perpendicular to a direction of substrate movement. When coating or processing substrates comprising a reduced with such coating equipment may become quite ineffective because a non-neglectible part of the coating material would be spoiled unused.

It is therefore desirable to provide an arrangement and a solution for individually adjusting an effective coating width of an evaporator such that the geometric extent or geometric expansion of evaporation material inside an evaporation chamber suitably adapts to the size or geometry of a substrate to be coated or processed. The solution should be realizable with moderate costs and expenditure. It should be easy to control and to provide an in situ adjustment of vapor expansion or vapor distribution.

### Summary

In one aspect there is provided an evaporator for use inside an evaporation chamber, typically inside an evaporation chamber of a coating arrangement. The evaporator is configured to evaporate an evaporation material, such as a molten evaporation material, such as a metallic material. The coating material to be deposited on a surface of a substrate via vapor deposition.

The evaporator comprises an evaporation crucible. The evaporation crucible comprises an evaporation cavity to contain evaporation material. The evaporation cavity may be configured to contain or to receive evaporation material, e.g. in a melted or solid state, and to allow evaporation of the evaporation material into an evaporated or gaseous state. The evaporator further comprises an outlet arrangement in flow connection with the evaporation cavity. Typically, and inside the evaporation crucible the evaporation material is melted or is provided in a melted state. It is then further heated for transition into the evaporated state.

The outlet arrangement comprises an evaporation aperture for evaporated evaporation material to flow from the evaporation cavity into the evaporation chamber. The aperture of the outlet arrangement comprises a flow-through cross-section of variable size and/or of adjustable size. The aperture of the outlet arrangement of variable and/or adjustable size allows to modify the geometric expansion and/or the geometric extent of the evaporated material escaping from the evaporation cavity towards the evaporation chamber surrounding the evaporator. In this way, the effective evaporation rate as well as the geometry, i.e. the geometric expansion and/or geometric extent of the evaporated material can be modified and can be adjusted to varying coating conditions as they may be determined by the geometry of the substrate.

In some examples the cross-section of the aperture of the outlet arrangement of the evaporator can be varied and/or adjusted during the evaporation or coating process. This allows an in situ adjustment or in situ variation of the size of the aperture of the outlet arrangement. In effect, the coating width of the evaporator may be adjusted or may be varied in accordance to a given width of a substrate to be coated. In this way, coating material can be used more efficiently and loss of material as well as contamination of the evaporation chamber can be reduced to a minimum.

Moreover, by enabling a variation or adjustment of the size or geometry of the flow-through cross section during a coating or evaporation process the evaporator can be almost instantly adjusted to variable coating or evaporation requirements. This way, a setup time for configuring or reconfiguring of the coating equipment can be reduced.

According to a further example the flow-through cross-section of the evaporation aperture is of variable geometry and/or of adjustable geometry. Hence, a width or length of the evaporation aperture may be changed or adjusted. This way, the size of the cross-section of the evaporation aperture may be varied by way of which also an effective evaporation rate, hence a flow of evaporated material escaping from the evaporation cavity towards and into the evaporation chamber can be modified or adjusted.

Moreover, the flow-through cross-section of the evaporation aperture may be also varied or adjusted by maintaining the overall size of the cross-section. In some examples the length of the evaporation aperture may be reduced by simultaneously increasing the width of the evaporation aperture. In this way, the geometry of the evaporation aperture, can be modified by way of which the geometric extent and/or the geometric expansion of the evaporated material escaping from the evaporation cavity can be modified accordingly.

Not only the length and/or width of the evaporation aperture but also a form factor of the evaporation aperture may be subject to a change. Hence, the geometry or the geometric form of the evaporation aperture may be changed, thereby also changing the overall geometry of the geometric expansion of the evaporated material released or escaping from the evaporation cavity.

According to a further example a position of the evaporation aperture relative to the evaporation crucible is variable and/or adjustable. Typically, the evaporation crucible is fixed inside the evaporation chamber. It may be arranged in a fixed relation to a substrate support and may be thus in a fixed position relative to a surface of a substrate to be coated or treated by the evaporated material. By varying or adjusting the position of the evaporation aperture relative to the evaporation crucible the geometric extent and/or expansion of the evaporated material released or escaping from the evaporation chamber towards the substrate can be changed and modified in relation to the substrate. Hence, by modifying or adjusting the position of the evaporation aperture an angle of incidence of evaporated material getting in contact with the surface of the substrate can be changed, varied or adjusted accordingly.

With a further example of the evaporator the outlet arrangement comprises a vapor guiding part with a sidewall. The sidewall comprises a guiding aperture extending through the sidewall. The guiding aperture may be a fixed aperture. It may be immobile relative to the evaporation crucible. The vapor guiding part may be a part of the evaporation crucible and may be integrated into the evaporation crucible, e.g. into a housing or sidewall structure formed or constituted by the evaporation crucible. The guiding structure may provide a well-defined guiding of evaporated evaporation material.

The guiding aperture extending through the sidewall may form part of the evaporation aperture of the outlet arrangement. In other examples the guiding aperture of the vapor guiding part may be a movable aperture. Also, the vapor guiding part may be implemented as a movable vapor guiding part, being movable relative to the evaporation crucible. In this way, the guiding aperture may change its position and/or direction thus enabling to modify a vapor escape angle or release direction of the evaporation material released from or escaping from the evaporation cavity towards and into the evaporation chamber.

According to a further example the outlet arrangement comprises a first movable part movable relative to the vapor guiding part. The first movable part comprises a movable sidewall to at least partially and variably or adjustably obstruct the guiding aperture of the vapor guiding part. By moving the movable sidewall of the first movable part at least partially across the guiding aperture, the effective size of the guiding aperture can be varied.

Typically, the movable sidewall of the first movable part is movable relative to the vapor guiding part and hence relative to the guiding aperture, such that the movable sidewall does not obstruct the guiding aperture, that the movable sidewall partially obstructs the guiding aperture or that the movable sidewall completely obstructs the guiding aperture. In this way, the available or effective size of the guiding aperture, through which the evaporation material may be released or through which the evaporation material may escape, is variable in size.

By moving the movable sidewall of the first movable part relative to the guiding aperture of the vapor guiding part the size of the flow-through cross section for the evaporated evaporation material can be changed and modified. This way, a degree of obstruction of the guiding aperture by the movable sidewall of the first movable part governs or controls the flow-through cross-section of the aperture of the outlet arrangement.

Typically and according to further examples there is provided a gasket or seal between the movable sidewall and the vapor guiding part so that vapor guided by and located inside the vapor guiding part flows through the non-obstructed part of the guiding aperture and past the movable sidewall of the first movable part.

According to a further example the vapor guiding part is movably disposed on or inside the vapor guiding part. In in this way the first movable part can be movably attached to the vapor guiding part. No further fastening structure may be required besides the vapor guiding part. The movable attachment of the first movable part to the vapor guiding part provides a rather direct and easy way of moving the first movable part with its movable sidewall relative to the guiding aperture of the vapor guiding part. This way, there can be provided a rather integrated solution for providing the guiding aperture with variable and adjustable size. Moreover, installation space for providing the first movable part in relation to the vapor guiding part can be reduced and available installation space can be optimized.

According to a further example the guiding aperture is an elongated aperture extending along a first direction. The first movable part is movable relative to the vapor guiding part along the first direction to vary a degree of obstruction of the guiding aperture by the first movable part, especially by the movable sidewall of the first movable part. The first movable part may be guided along the elongated aperture of the guiding aperture. In some examples the first movable part may be fastened or connected to the vapor guiding part by a slide guiding. This way, there can be provided a rather controlled and precise movement of the first movable part relative to the vapor guiding part thus allowing to provide rather reproducible variations or adjustments of the flow-through cross-section of the aperture of the outlet arrangement.

The first movable part may be fixed to or relative to the guiding aperture or vapor guiding part in any position or orientation relative to the guiding aperture or vapor guiding part.

According to a further example the outlet arrangement comprises a further first movable part movable relative to the vapor guiding part, e.g. movably disposed on or inside the vapor guiding part, and comprising a movable sidewall to at least partially obstruct the guiding aperture of the vapor guiding part. The first movable part is movably disposed at or near a first longitudinal end of guiding aperture. The further first movable part is movably disposed at or near a second longitudinal end of the guiding aperture opposite to the first longitudinal end of the guiding aperture. In this way, both longitudinal and opposite ends of the guiding aperture can be provided with a separate first or with a further first movable part, respectively.

The first movable part and the further first movable part may be implemented somewhat identically. By moving the first movable part relative to the guiding aperture, the position of the first longitudinal end of the guiding aperture can be effectively modified. Likewise, the second longitudinal end of guiding aperture can be obstructed in accordance to a varying position or location of the further first movable part.

In some examples and when reducing the distance between the first movable part and the further first movable part of the overall longitudinal extent of the guiding aperture of the vapor guiding part can be reduced. By increasing the distance between the first movable part and the further first movable part at the longitudinal extent of the guiding aperture of the vapor guiding part can be increased.

By moving the first movable part and the further first movable part in unison, e.g. in a same or common direction by the same distance, the overall size of the guiding aperture may remain unamended and constant while its position relative to the vapor guiding part may change accordingly. In this way, the position of a vapor escape aperture or vapor release aperture, hence the effective position of the aperture of the outlet arrangement can be modified.

In some examples, the first movable part and the further first movable part may be mechanically coupled. A movement of the first movable part may be thus automatically transferred to a respective movement of the further first movable part. In other examples, the first movable part, and the further first movable part may be movable separately or independently from another. They may be mechanically decoupled from one another.

For instance, the longitudinal direction of the guiding aperture and hence of the aperture of the outlet arrangement formed by the guiding aperture may extend substantially perpendicular to an elongation or movement direction of the substrate. Insofar, the longitudinal extent of the guiding aperture may be oriented along the transverse width of the substrate. By modifying or adjusting a position of the first movable part and the further first movable part, the respective oppositely located longitudinal ends of the guiding aperture may be precisely adjusted in accordance to the lateral edges of the substrate to be coated or treated by the evaporated evaporation material. In this way and by the first movable part and the further first movable partner not only the total length or width of the guiding aperture of the vapor guiding part but also its position relative to the evaporation crucible and/or relative to the substrate or substrate support can be modified.

According to a further example the first movable part comprises a first outlet aperture in the movable sidewall to at least partially overlap with the guiding aperture of the guiding part. In this way, the effective size and/or the geometry of the flow-through cross-section of the aperture of the outlet arrangement may be adjusted in accordance to the degree of overlapping of the guiding aperture of the vapor guiding part and the outlet aperture of the movable part. The outlet aperture in the movable sidewall may be of a substantial identical or of a different geometry or size than the guiding aperture of the vapor guiding part.

In some examples the first outlet aperture may be somewhat equal in size or geometry compared to guiding aperture of the vapor guiding part. Then and when bringing the first outlet aperture and the guiding aperture in a substantially overlapping configuration the size of the flow-through cross-section of the aperture of the outer arrangement may be maximized. By moving the first movable part with its first outlet aperture relative to the vapor guiding part, the sidewall adjoining or enclosing the first outlet aperture of the movable part may start to obstruct or to at least partially obstruct the guiding aperture of the vapor guiding part; or vice versa.

The sidewall of the vapor guiding part may at least partially obstruct the first outlet aperture of the movable sidewall of the first movable part. In effect, the available aperture, hence the remaining aperture which is available for a flow-through of evaporated evaporation material is reduced in size and/or modified in geometry.

With the first movable part comprising a first outlet aperture the variations of the geometry or variations or adjustments of the size of the aperture of the outlet arrangement can be modified and/or adjusted with a higher degree of flexibility. In detail, there can be provided a comparatively high degree of variations of the geometric size, position and form of the flow-through cross-section of the aperture of the outlet arrangement formed by the first outlet aperture at least partially overlapping with the guiding aperture of the vapor guiding part.

According to a further example the first movable part is movable relative to the vapor guiding part to vary a degree of overlapping of the first outlet aperture and guiding aperture. Depending on the respective form factors or geometries of the first outlet aperture and the guiding aperture and depending on a direction of relative movement between the first movable part and the vapor guiding part there can be provided a large variety of different sizes, positions and/or forms of the remaining open flow-through aperture of the outlet arrangement.

According to a further example the first movable part is removably disposed on or inside the vapor guiding part. Here, the first movable part may be movable with regards to a first direction and/or with regard to a second direction relative to the vapor guiding part.

According to another example the sidewall of the guiding part is of tubular shape and the first movable part is rotatable relative to the sidewall with a longitudinal axis of the sidewall as an axis of rotation. Also here, the guiding aperture may extend along a longitudinal extent of the vapor guiding part. A width of the guiding aperture may extend or may be oriented in circumferential direction of the tubular shaped sidewall of the guiding part. In this way and by rotating the first movable part relative to the sidewall of the vapor guiding part a degree of overlapping or obstruction of the guiding aperture and the first outlet aperture can be easily modified.

In some examples, the axis of the sidewall according to which the sidewall of the first movable part is rotatable may substantially coincide with a longitudinal axis or symmetry axis of the guiding part.

According to some examples the first movable part is rotatably supported by the vapor guiding part. Hence, the first movable part may be a pivotally or rotatably attached to the vapor guiding part. It may be pivotably attached so as to swivel with regards to an axis of rotation. This provides a rather well-defined movability of the first movable part relative to the vapor guiding part.

In some examples also the first movable part may comprise a tubular shape. It may be arranged coaxially with the tubular shape of the vapor guiding part.

The first movable part may be either rotatably or coaxially arranged inside the vapor guiding part or outside the vapor guiding part. In any case, the first outlet aperture of the first movable part may be movable relative to the guiding aperture of the vapor guiding part so as to modify a degree of mutual obstruction and/or overlapping of the guiding aperture and the first outlet aperture by way of which the size, geometry or position of the aperture of the outer arrangement of the evaporator can be modified.

According to a further example one of guiding aperture and the first outlet aperture comprises an elongated slit. The other one of guiding aperture and the first outlet aperture comprises one of a rectangular, a triangular, a rhombic, a round, an elliptic or an oval shape. By providing the guiding aperture and the first outlet aperture with a different aperture geometry, there can be provided a variation of the geometry of the aperture of the outlet arrangement when the first movable part is subject to a movement relative to the guiding part, i.e. when the first outlet aperture is subject to a movement relative to guiding aperture, such that the degree of overlapping of the respective aperture is subject to a respective change.

In further examples the overall geometry of the guiding aperture and of the first outlet aperture may be somewhat identical. Of course, the geometric dimensions of the guiding aperture and the first outlet aperture may distinguish from each other. Hence, in some examples, the guiding aperture may comprise a rectangular shape. The outlet aperture may also comprise a rectangular shape. The longitudinal and transverse sizes of the respective apertures of the guiding aperture and the first outlet aperture may distinguish from each other. Also in this way, there can be provided varying overall shapes of a remaining aperture of the outlet arrangement as the first movable part is subject to a movement relative to the vapor guiding part.

Moreover, with one of the first outlet aperture and the guiding aperture comprising an elongated slit and the other one of the first outlet aperture and the guiding aperture comprises a rhombic or triangular shape there can be effectively provided a continuous size and position variation of the resulting aperture of the outlet arrangement as the first movable part is e.g. moved or rotated relative to the vapor guiding part.

For instance, the triangular legs of a triangular aperture may extend at a predefined angle relative to the longitudinal extent of another aperture comprising an elongated slit. Here, the elongated slit may form a virtual connection between the oppositely located triangular legs of the triangular aperture of one of the guiding aperture and the first outlet aperture. The elongated slit of the other one of guiding aperture and the first outlet aperture may then extend between the opposite triangular legs.

By moving the first movable part relative to the vapor guiding part the relative position of the triangularly shaped aperture and the elongated slit may change such that the distance between the triangular legs virtually connected by the elongated slit changes. In this way, the effective length and hence the effective size of the elongated slit forming the aperture of the outlet arrangement can be varied and adjusted. Here, a movement of the first movable part relative to the vapor guiding part may be a rotational movement, which may be rather easy to implement in an evaporator.

Moreover, when the first movable part is coaxially arranged inside or on the outside of the tubular shaped vapor guiding part, a size variation, e.g. a variation of the longitudinal extent of the aperture, e.g. in the longitudinal or axial direction of the tubular guiding part can be simply provided by rotating the first movable part relative to the vapor guiding part. In this way the longitudinal size of the aperture can be modified without the necessity to move the first movable part along the longitudinal or axial direction but simply by a rotation relative to the guiding part with a center axis as an axis of rotatition. This allows for an implementation of the evaporator with constant lengths along the direction of the elongation of the tubular shaped vapor guiding part.

According to a further example the outlet arrangement comprises a second movable part, which is movable relative to the vapor guiding part and comprises a movable shutter to at least partially and variably or adjustably obstruct the guiding aperture of the vapor guiding part. The second movable part may be provided in addition to the first movable part and also in addition to the further first movable part. The second movable part may be movable along a second direction whereas first movable part may be movable along a first direction. The first and the second direction may distinguish from each other. In some examples the first and second directions may be oriented in a same or common direction. In some examples the second movable part is movable relative to the vapor guiding part and/or relative to the first movable part along the second direction. The second direction may be oriented perpendicular to the first direction.

In some examples, the first direction may be oriented along the elongation of the vapor guiding part and the second direction may be oriented transverse to the orientation of the longitudinal extent of the vapor guiding part.

In some examples and when the guiding aperture as provided in the sidewall of the vapor guiding part is an elongated slit and substantially extends along the longitudinal extent of the vapor guiding part of the first movable part and the first and/or the further first movable part may be movable relative to the vapor guiding part along the first direction, which may coincide with the direction of elongation of the vapor guiding part. Then, the second movable part may be movable in a transverse direction, each e.g. perpendicular to the first direction. Here, the first movable part and the optional further first movable part may serve to modify the elongation and hence the longitudinal extent of the guiding aperture.

The second movable part with its movable shutter may serve to modify and/or to reduce the size of the guiding aperture along the second direction, e.g. along a transverse direction of the vapor guiding part. In this way, not only the effective length but also the width of the guiding aperture as provided in the sidewall of the vapor guiding part can be modified. Here, the first movable part and/or the further first movable part serve to adjust or to modify the longitudinal extent of a slit-like guiding aperture whereas the second movable part serves to modify or to reduce the width of such an aperture.

According to another example the outlet arrangement comprises a second movable part which is movable relative to the vapor guiding part and comprises a second outlet aperture to partially and variably or adjustably overlap with the guiding aperture.

Also here, the second outlet aperture may at least partially obstruct the first outlet aperture and/or the guiding aperture. The region by way of which the guiding aperture, the first outlet aperture and the second outlet aperture overlap forms or constitutes the aperture of the outlet arrangement through which the evaporated evaporation material may be released or may escape from the evaporation cavity towards and into the surrounding evaporation chamber.

The second movable part may be of tubular shape and may be arranged coaxial with the first movable part and/or coaxial with the vapor guiding part. The second movable part may be arranged inside the first movable part. It may be arranged outside the first movable part and inside the vapor guiding part. In further examples the second movable part may be arranged outside the vapor guiding part and outside the first movable part. It may be also arranged between the first movable part and the vapor guiding part. Between the first movable part, the vapor guiding part and the second movable part there may be provided at least one or several gaskets, which allow(s) for a relative movement between the first movable part, the second movable part and the vapor guiding part, respectively.

The gasket(s), e.g. forming a seal between the guiding aperture, the first outlet aperture and the second outlet aperture provides a rather lossless release or escape of evaporated evaporation material from the evaporation cavity through the at least partially overlapping apertures, namely through the guiding aperture, the first outlet aperture and the second outlet aperture, respectively.

Also, the second movable part may be movably disposed on or inside the vapor guiding part. It may be movably disposed on or inside the first movable part.

According to further examples at least one of the guiding aperture, the first outlet aperture and the second outlet aperture each comprise an elongated slit, wherein another one of the guiding aperture, the first outlet aperture and the second outlet aperture comprises one of a rectangular, a triangular, a rhombic, a round, an elliptic or an oval shape.

It is also conceivable, that only one of the guiding aperture, the first outlet aperture and the second outlet aperture comprises an elongated slit and that another two of the guiding aperture, the first outlet aperture and the second outlet aperture comprises one of a rectangular, a triangular, a rhombic, a round, an elliptic or oval shape. This way, a large variety of size and geometric variations of the aperture of the outlet arrangement can be provided depending on the relative position or orientation of the first movable part, the second movable part and the vapor guiding part relative to each other.

According to another aspect there is provided a coating arrangement for coating a surface of a substrate through vapor deposition. The coating arrangement comprises an evaporation chamber to receive the substrate. The coating arrangement further comprises an evaporator as described above and in direct flow connection with an interior of the evaporation chamber.

Here, and with some examples the evaporator may be arranged inside the evaporation chamber. With other examples the evaporator may be located or arranged outside the evaporation chamber such that the outlet arrangement thereof is in direct flow communication with the interior of the evaporation chamber. When the evaporator is arranged outside the evaporation chamber the outlet arrangement of the evaporator may extend into or through a chamber wall of the evaporation chamber such that the evaporation aperture of the outlet arrangement is in direct flow communication with the interior of the evaporation chamber.

The evaporation chamber may be implemented as a vacuum chamber. It may be evacuated by a vacuum pump. Insofar, the coating arrangement may be operable to coat a surface located inside the evaporation chamber under vacuum conditions.

The coating arrangement may be implemented as a coating arrangement suitable for physical vapor deposition (PVD). The evaporator may be fixed inside the evaporation chamber and provides an outlet arrangement with an aperture comprising a flow-through cross-section of variable and/or adjustable size, position or orientation. In this way, the geometric extent or geometric expansion of evaporated evaporation material released or escaping through the outlet arrangement of the evaporator can be adjusted, e.g. in situ during a coating process. Accordingly, and specifically a width of a vapor expansion can be precisely adapted to the width of the substrate, e.g. in a direction perpendicular to a movement direction or direction of elongation of the substrate.

Typically, the coating arrangement comprises a vacuum pump for evaporating the evaporation chamber.

The coating arrangement further comprises a heating for heating the evaporation crucible so as to transform the evaporation material inside the evaporation crucible into the gaseous state so as to produce evaporated evaporation material that expands inside the evaporation cavity and which releases or escapes from the evaporation cavity through the outlet arrangement.

According to a further example the substrate comprises one of a continuous band or strip of material and a sheet of material, which is continuously moving relative to the evaporator along a transport direction. Accordingly, the coating arrangement comprises a respective transport device suitable for continuously feeding or moving the band- or sheet-like substrate relative to the evaporator. The flow-through cross-section of the aperture of the evaporator, which is variable and/or adjustable in size along a first direction, extends at a predefined angle relative to the transport direction. Typically, and in some examples the first direction extends perpendicular to the transport direction or to the direction of the main elongation of the substrate.

In some examples the substrate transport direction extends substantially vertically. Here, the evaporator may be arranged laterally or horizontally offset from the substrate and the outlet arrangement may face in a horizontal direction towards the substrate. in other examples the substrate transport direction extends substantially horizontally. Here, the evaporator may be arranged vertically offset from the substrate. May be arranged below the substrate and the outlet arrangement may face upwardly towards the substrate.

The coating arrangement comprises the evaporator as described above. Insofar all features, effects and benefits as described above in connection with the evaporator equally apply to the coating arrangement; and vice versa.

In some examples the substrate comprises a sheet of steel or metal. In other examples the substrate comprises a continuous strip or band of metal or steel to be coated with a metallic or metallic alloy evaporation material comprising at least one or a combination of the following materials: zinc, aluminum, nickel, chrome, magnesium or titanium.

In some examples the coating arrangement is configured to coat a surface of the substrate with an anti-corrosive layer or anti-corrosive coating. In some examples, the vacuum coating system is configured for coating a band-type metallic substrate, such as a steel, with a metallic material or metallic alloy comprising at least one or a combination of at least one or more of the following materials: zinc, aluminum, nickel, chrome, magnesium or titanium, e.g. by way of physical vapor deposition (PVD).

In another aspect the present disclosure also relates to a method of coating a surface of a substrate inside an evaporation chamber of a coating arrangement as described above. Typically, the method is configured for a continuous coating of a surface of a movable substrate. The method comprises the steps of continuously moving the substrate along a transport direction, directing evaporated evaporation material onto the surface of the moving substrate and adjusting the size of a flow-through cross-section of the aperture of the outlet arrangement of the evaporator, e.g. to a width of the substrate in a direction perpendicular to the transport direction.

The method as described herein is particularly configured to be implemented by the evaporator as described above and/or by the coating arrangement as described above.

Insofar, all effects, features and benefits as described above in connection with the evaporator and the coating arrangement equally apply to the method of coating a surface of the movable substrate; and vice versa.

### Brief Description of the Drawings

In the following, some examples of the evaporator and the coating arrangement and a method of coating a substrate are described in greater detail by making reference to the drawings, in which:
- Fig. 1: schematically shows a cross-section through an evaporator arranged inside an evaporation chamber, through which a substrate is moved,
- Fig. 2: shows an exemplary side view of the evaporator in relation to a width of the substrate in a first configuration,
- Fig. 3: shows the arrangement of Fig. 2 in a further configuration, wherein the width of the aperture is adjusted to the width of the substrate,
- Fig. 4: shows a cross-section through an example of the evaporator,
- Fig. 5: is an isolated view of a vapor guiding part,
- Fig. 6: is an isolated perspective view of a first movable part,
- Fig. 7: is a perspective illustration of an assembly of the vapor guiding part and the first movable part of Figs. 5 and 6,
- Fig. 8: shows an isolated perspective view of a second movable part,
- Fig. 9: shows the assembly of the vapor guiding part, with first and second movable parts,
- Fig. 10: is a further cross-section through another example of an evaporator,
- Fig. 11: shows a further example of a vapor guiding part with a first movable part and a further first movable part,
- Fig. 12: shows the arrangement of Fig. 11 with the first movable part and the further first movable part movably arranged inside the vapor guiding part,
- Fig. 13: shows the vapor guiding part with a second movable part,
- Fig. 14: shows the arrangement of Fig. 12 together with the second movable part,
- Fig. 15: shows another example of the evaporator in cross-section,
- Fig. 16: shows a side wall and a bottom section of an example of the evaporation crucible,
- Fig. 17: shows another example of a sidewall and a bottom section of the evaporation crucible and
- Fig. 18: is a flowchart of the method of coating a surface making use of the evaporator and the coating arrangement.

### Detailed description

Fig. one shows a schematic example of a coating arrangement 1. The coating arrangement 1 comprises an evaporation chamber 8 inside which an evaporator 10 is arranged. The evaporation chamber 8, which may form a vacuum chamber, can be evacuated by an evaporation pump 6. This way, a pressure P1 inside the evaporation chamber 8 may be substantially lower than a pressure P2 outside the evaporation chamber 8. Inside the evaporation chamber 8 there is arranged an evaporation arrangement 5. The evaporation arrangement 5 comprises the evaporator 10 and a heating 16, 18, by way of which the evaporator 10 can be heated to an evaporation temperature.

The evaporator 10 comprises an evaporation crucible 20. The evaporation crucible 20 confines an evaporation cavity 19. Inside the evaporation cavity 19 there can be stored or contained an evaporation material 12. The evaporation material 12 can be stored in a liquid state inside the evaporation cavity 19. Here, the evaporation material is a molten evaporation material 12. Alternatively, the evaporation material is provided or supplied into the evaporation crucible in a solid state. By feeding the evaporation crucible 20 with the molten evaporation material 12, the evaporation material further heated inside the evaporation crucible may evaporate and may transfer or transform into evaporated evaporation material 14 thus filling the cavity 19 above the fluid level 15 of the molten evaporation material 12.

The evaporation crucible 20 comprises a sidewall 21 and a bottom 22. The evaporation crucible 20 may be closed towards an upper side by a top 23. At least one of the sidewall 21 and the top 23 of the evaporation crucible 20 comprises an outlet arrangement 24. The outlet arrangement 24 comprises an evaporation aperture 26. The evaporation aperture 26 comprises a flow-through cross-section of variable and/or of adjustable size. Evaporated evaporation material 14 is allowed to flow from the evaporation cavity 19 through the evaporation aperture 26 into the surrounding evaporation chamber 8 and hence outside the evaporation crucible 20.

Inside the evaporation chamber 8 there is further provided a substrate 2. The substrate 2 comprises a surface 3 to be treated, e.g. to be coated with evaporated evaporation material by physical vapor deposition. The outlet arrangement 24 may comprise or may form a nozzle section 25 through which the evaporated evaporation material 14 may flow in a controlled manner towards the surface 3 of the substrate 2.

The evaporation chamber 8 comprises a chamber wall 11, which is substantially closed apart from an optional through opening, through which the substrate 2 may be transported through the evaporation chamber 8 along a transport direction 9. The chamber wall 11 may be further intersected by a supply for the evaporation arrangement 5 or evaporator 10. The supply comprises a pipe 28, which is heated by a heating 18 and which is in flow communication with the evaporation cavity 19. Via the pipe 28 the evaporation material may be melted outside the evaporation chamber 8 and may be supplied to and into the evaporation cavity 19 in the liquid or molten state.

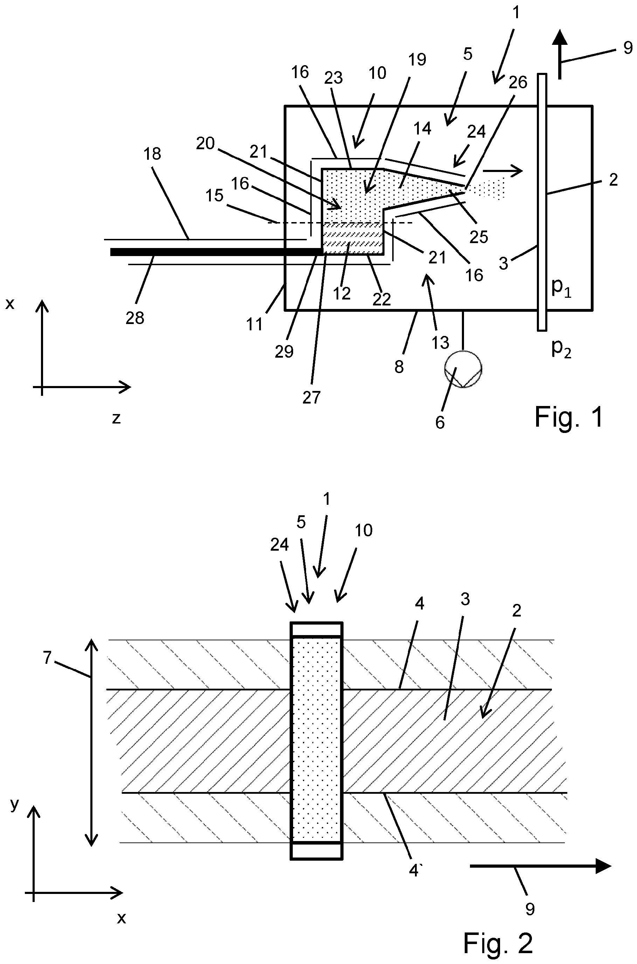

The chamber wall 11 confines an interior 13 of the evaporation chamber 8. Typically, and as illustrated in Fig. 1 the evaporator 10 is located inside the interior 13 of the evaporation chamber 8. In other examples the evaporator 10 may be located outside the evaporation chamber 8. But then the outlet arrangement 24 of the evaporator 10 is located inside the interior 13 of the evaporation chamber or is at least in direct fluid communication with the interior 13. The outlet arrangement 24, at least the evaporation aperture may intersect the chamber wall 11 from outside such that the evaporation aperture 26 is in direct flow communication with the interior 13. An arrangement of the evaporator 10 outside the evaporation chamber 8 may facilitate supply of molten or solid evaporation material into the evaporation crucible 20.

Typically or preferably, an end section 29 of the supply pipe 28 is in flow communication with an inlet 27 of the evaporation crucible 20 at or near a lower portion of the sidewall 21 and/or near or in the bottom 22 of the evaporation cavity 19 or evaporation crucible 20. With some examples the pipe 28 or supply for the molten evaporation material 12 may be in flow communication with the bottom 22 of the evaporation crucible 20. This way, there may be provided a bottom side supply of molten evaporation material 12, which may easily allow to empty the evaporation crucible 20 in case of a downtime or setup of the evaporator 10 or evaporation arrangement 5.

In some examples the substrate 2 is an elongated band or sheet of a metallic material, such as a strip or band of steel to be processed, e.g. coated with an anti-corrosive coating. The coating may be provided by the evaporation material 12, 14 deposited onto the surface 3 by way of physical vapor deposition.

In some examples the substrate 2 may be subject to a continuous movement along the transport direction 9 relative to the evaporation arrangement 5 and/or relative to the evaporator 10. In order to provide a continuous, homogenous and high-quality coating on the surface 3 of the substrate 2 it is therefore desirable to provide a homogeneous distribution or homogeneous geometric expansion of evaporated evaporation material 14 in the vicinity of the surface 3 of the moving substrate 2.

In the example of Fig. 1 the substrate 2 extends vertically and the substrate transport direction 9 is parallel to the extension of the planar-shaped band-type substrate 2. Hence, the substrate transport direction 9 also extends vertically. The evaporator 10 is located laterally, i.e. horizontally offset from the substrate 2 with the outlet arrangement 24 facing towards the substrate 2. The outlet arrangement 24, and in particular the aperture 26 of the outlet arrangement 24 faces in horizontal direction towards the surface 3 of the substrate 2.

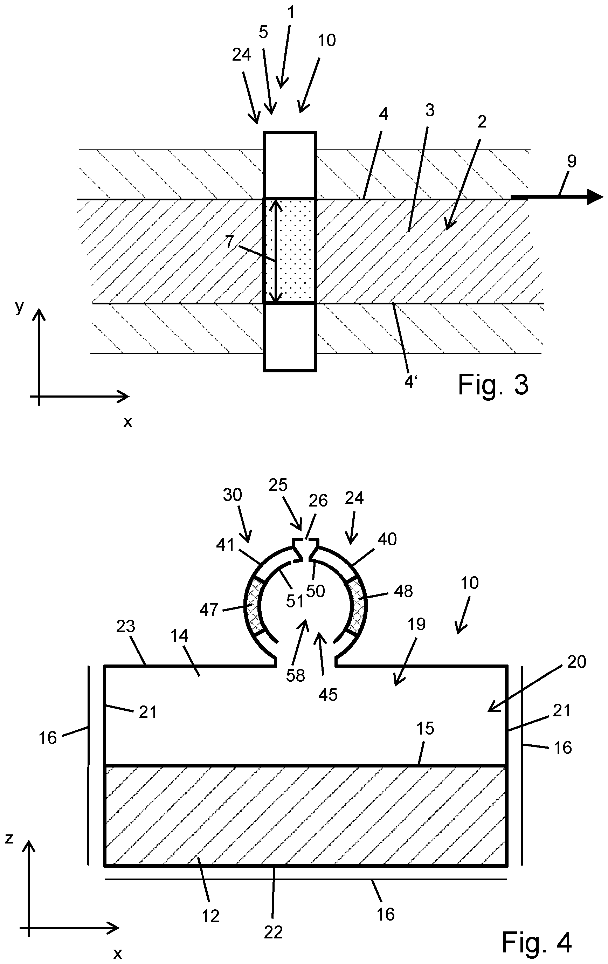

The outlet arrangement 24 of the evaporator 10 comprises a flow-through cross-section of variable and/or adjustable size as will become apparent from a comparison of Figs. 2 and 3. In Fig. 2 the elongated structure of the outlet arrangement 24 along a first direction (y) is illustrated while the substrate 2 is moved along a second direction (x). As it is immediately apparent from Fig. 2 the elongation of the evaporation aperture 26 and hence the elongation of the outlet arrangement 24 along the first direction (y) defines a coating width 7, which in the example of Fig. 2 is larger than the respective extent of the substrate 2 along this first direction (y). The opposite ends of the coating width 7 are separated at a distance that exceeds the respective extent of the surface 3 of the substrate 2 as defined by the opposite side edges 4, 4' of the substrate 2. In this configuration a non-neglectible amount of the evaporated evaporation material 14 is effectively lost and may contaminate the surrounding of the substrate 2 and hence the interior of the evaporation chamber 8.

For optimizing the coating process and for reducing losses of evaporation material 12, 14 the outlet arrangement 24 provides an aperture adjustment 30 by way of which the size and/or geometry and/or position of the flow-through cross-section of the evaporation aperture 26 can be adjusted and/or modified. As illustrated in Fig. 3, the effective coating width 7 of the outlet arrangement 24 and hence of the evaporation aperture 26 has been reduced in order to match with the width of the substrate 2, which is defined by a distance between the opposite side edges 4, 4' of the substrate 2.

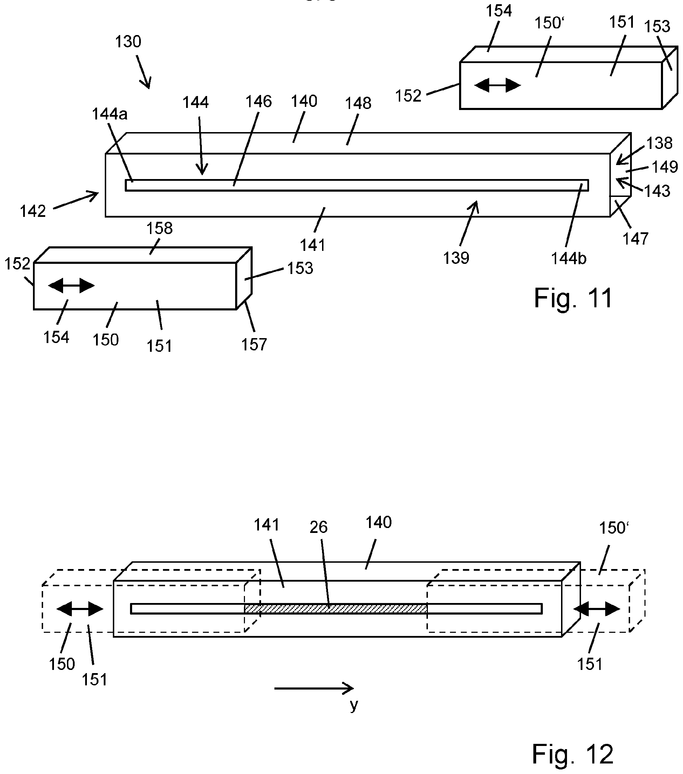

There are different ways to obtain or to realize an evaporation aperture 26 with a variable and/or adjustable flow-through cross section as will become apparent from the examples as shown in Figs. 4 to 10 or as illustrated by the example as shown in Figs. 11-15.

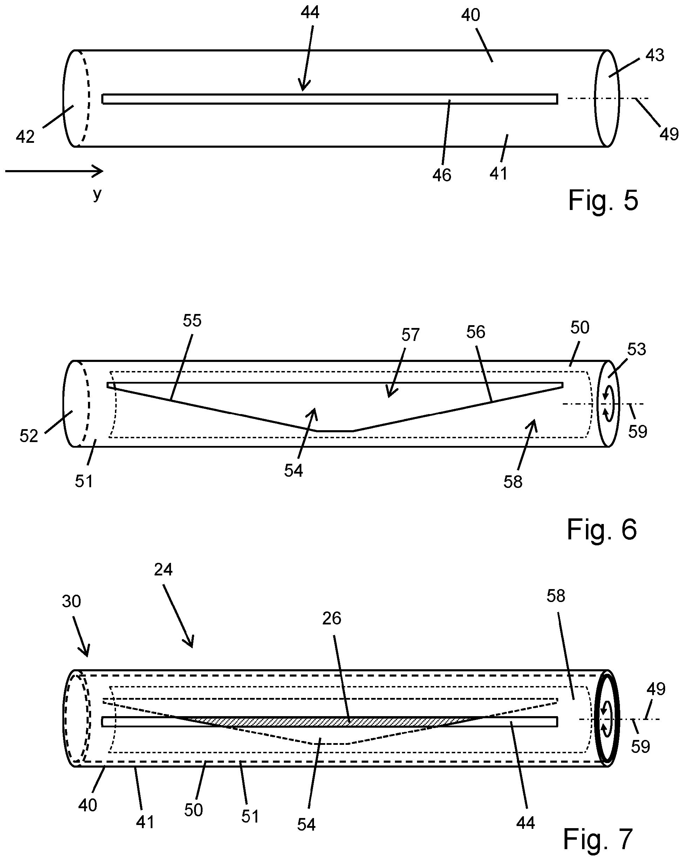

With the example according to Figs. 4-10 there is provided a vapor guiding part 40 of tubular structure. The vapor guiding part 40 is in permanent flow communication with the evaporation cavity 19. The vapor guiding part 40 comprises a tubular-shaped sidewall 41 featuring an inlet opening 45 extending all along the elongation of the sidewall 41 of the vapor guiding part 40 as becomes apparent from Fig. 4. The inlet aperture 45 is not particularly illustrated in the perspective illustration of Fig. 5. The sidewall 41 is hence intersected by the inlet aperture 45 and the interior of the tubular-shaped sidewall 41 is and remains in permanent flow communication with the evaporation cavity 19. This way, evaporated evaporation material 14 generated by vaporization of molten evaporation material 12 inside the evaporation cavity 19 is able to flow into the interior of the sidewall 41 of the vapor guiding part 40.

The vapor guiding part 40 further comprises an aperture 44, denoted as a guiding aperture 44 extending through the sidewall 41 as illustrated in Fig. 5. The guiding aperture 44 comprises an elongated slit 46 extending along the first direction (y), the elongated slit 46 may extend parallel to a center axis 49 of the tubular-shaped sidewall 41. The sidewall 41 and hence the vapor guiding part 40 may be closed towards both opposite longitudinal ends by end walls 42, 43. In this way, vapor entering the interior of the vapor guiding part 40 through the inlet aperture 45 may only escape from the vapor guiding part 40 through the guiding aperture 44.

The outlet arrangement 24 further comprises a first movable part 50 as illustrated in Fig. 6. The first movable part 50 may also comprise a tubular-shaped sidewall 51 with oppositely located end walls 52, 53 and an outlet aperture 54 extending though the sidewall 51. The sidewall 51 further comprises an inlet aperture 58, which is circumferentially offset from the outlet aperture 54. The sidewall 51 comprises a center axis 59, which in an assembly configuration with the vapor guiding part 40 may coincide or which may substantially overlap with the center axis 49 of the vapor guiding part 40 as illustrated in Fig. 7.

In the presently illustrated example an outside diameter of the first movable part 50 is slightly smaller than an inside diameter of the vapor guiding part 40. This allows for a nested arrangement and hence an interleaved or telescopic arrangement of the first movable part 50 inside the tubular sidewall 41 of the vapor guiding part 40. The first movable part 50 may be rotationally supported inside the vapor guiding part 40. It may be rotatable relative to the vapor guiding part 40 with regard to the rotation axis 49.

The inlet aperture 58 substantially coincides and overlaps with the inlet aperture 45. This way, evaporated evaporation material 14 is allowed to flow into the interior of the first movable part 50. The first movable part 50 comprises an outlet aperture 54 of rhombic or triangular shape. The outlet aperture 54 comprises a first beveled section 55 and a second beveled section 56. The beveled sections extend at a predefined angle relative to the elongation of the rotation axis 49. In the assembly configuration as illustrated in Fig. 7 the outlet aperture 54 of the movable part 50 overlaps with the guiding aperture 44 and hence with the elongated slit 46 of the vapor guiding part 40. This way, there can be provided a resulting evaporation aperture 26, which is formed by the non-obstructed portions of the outlet aperture 54 and the guiding aperture 44.

As shown in Fig. 7, the oppositely located beveled portions or beveled sections 55, 56 delimit the longitudinal extent of the guiding aperture 44. Hence, the sidewall 51 of the movable part 50 adjacent to the beveled section 55, 56 at least partially obstruct portions of the elongated slit 46 and hence of the guiding aperture 44.

In this way, the remaining evaporation aperture 26, formed by the overlapping regions of the outlet aperture 54 and the guiding aperture 44 is variable and/or adjustable in size.

By rotating the movable part 50 in a first sense of rotation relative to the vapor guiding part 40 the portion of the beveled section 55, 56 overlapping with the guiding aperture 44 is subject to a respective modification thus resulting in an increase of the longitudinal extent of the evaporation aperture 26. When rotating or moving the first movable part 50 in an opposite and hence in a second sense of rotation the longitudinal extent and hence the size of the evaporation aperture 26 decreases accordingly.

By way of the beveled sections 55, 56, that can be provided a continuous and stepless size variation of the evaporation aperture 26 when the first movable part 50 is moved, e.g. rotated relative to the vapor guiding part 40.

As will become apparent from the cross-section of Fig. 4 there is provided at least one gasket 47, 48 between an outside surface of the sidewall 51 of the movable part 50 and an inside surface of the sidewall 41 of the vapor guiding part 40. In this way it can be provided that evaporation material 14 flowing through the outlet aperture 54 of the movable part 50 does not escape in an uncontrolled manner between the sidewalls 41, 51 but escapes from the evaporation cavity 19 exclusively through the overlapping portions of the outlet aperture 54 and the guiding aperture 44. The first movable part 50 and the vapor guiding part 44 form or constitute the aperture adjustment 30 by way of which the longitudinal extend and/or the position of the evaporation aperture 26 as seen in circumferential direction can be continuously changed and/or adjusted.

In any conceivable position of orientation of the first movable part 50 relative to the vapor guiding part 40, the first movable part 50 may be fixed relative to the vapor guiding part 40, thereby maintaining a predefined size or geometry of the evaporation aperture 26.

It is further to be noted, that the evaporator 10 according to the example of Fig. 4 comprises the outlet arrangement 24 at the top 23 of the evaporation crucible 20. Such a configuration of an evaporator 10 is particularly suitable for a horizontal transport direction of the substrate 2. Here, the evaporator 10 is particularly configured for an arrangement vertically below the substrate 2. The aperture 26 of the outlet arrangement 24 may face upwardly towards a lower side or lower surface 3 of the moving substrate 9.

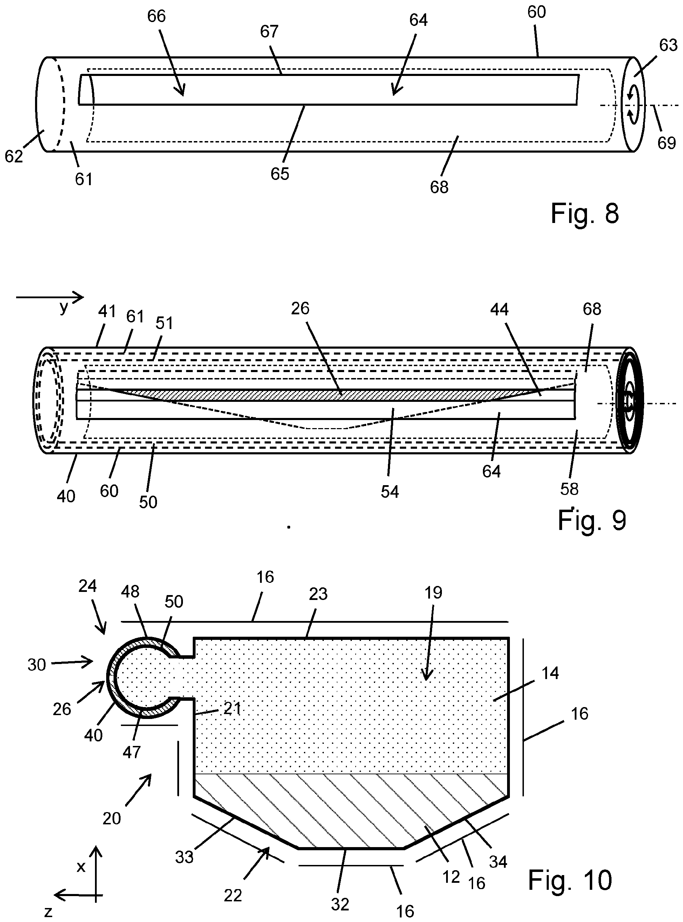

Optionally, the aperture adjustment 30 as shown in Fig. 7 may be also provided with a second movable part 60 as separately shown in Fig. 8. The second movable part 60 may also comprise a tubular shape and may feature a tubular or cylindrically-shaped sidewall 61 closed at opposite longitudinal ends by a respective end wall 62, 63. The second movable part 60 may be movably disposed on or inside one of the first movable part 50 and the vapor guiding part 40. It may be rotatable with regards to a center axis as a rotation axis 69. The sidewall 61 of the second movable part 60 comprises a second outlet aperture 64.

Circumferentially offset from the second outlet aperture 64 there is provided a second inlet aperture 68, which suitably overlaps with the first inlet aperture 58 and with the inlet aperture 45. The second movable part 60 with its second outlet aperture 64 may be movable relative to the first movable part 50 and relative to the vapor guiding part 40. It may be movable independent of a movement of the first movable part 50. The second outlet aperture 64 is of rectangular shape. It may comprise or form an elongated slit 66. The circumferential size of width of the elongated slit 66 may be larger or smaller than the respective circumferential size or width of the elongated slit 46 or guiding aperture 44. In effect, and by moving the second movable part 60 relative to at least one of the vapor guiding part 40 and the first movable part 50 the effective width of the resulting evaporation aperture 26, hence the extent of the flow-through evaporation aperture 26 along the circumferential direction can be modified.

Hence, with the presently the illustrated example a movement of the first movable part 50 relative to the vapor guiding part 40 provides a modification or adjustment of the longitudinal extent of the evaporation aperture 26. By way of a movement of the second movable part 60 relative to the vapor guiding part 40 and/or relative to the first movable part 50 the extend or size of the evaporation aperture 26 along the circumferential direction can be modified and/or adjusted.

The triangular shape of the first outlet aperture 54 is only one example of a large variety of conceivable geometries of the first outlet aperture 54. With a rhombic or triangularly shaped first outlet aperture 54 there can be provided a size variation and form variation of the resulting evaporation aperture 26 along the first direction (y) and hence along the longitudinal extend or axial direction of the vapor guiding part 40 when the first movable part 50 is subject to a movement along a circumferential direction, hence along a second direction relative to the vapor guiding part 40. In this way, the longitudinal size of the evaporator 10 is not subject to modifications when realizing a longitudinal size adjustment of the evaporation aperture 26.

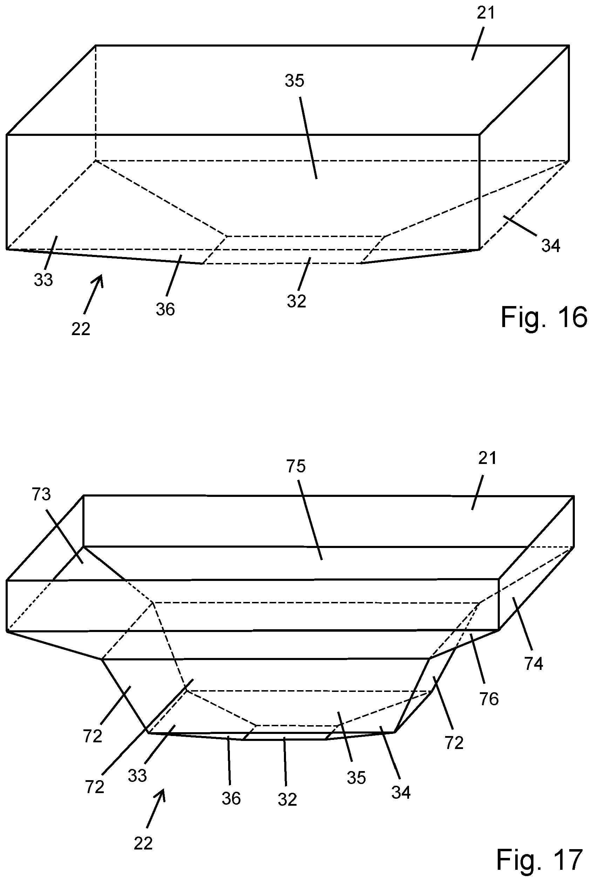

As becomes further apparent from the cross-section of Fig. 10 the aperture adjustment 30 and the entire outlet arrangement 24 may be arranged at or near an upper end of the sidewall 21 of the evaporation crucible 20. It may be arranged adjacent to the closed top 23 of the evaporation crucible 20. The bottom 22 of the evaporation crucible 20 may comprise numerous bottom sections 32, 33, 34 as shown in Fig. 10 and 16. Here, the bottom 22 may comprise a central and rather planar-shaped bottom section 32, which adjoins or transitions into a somewhat vertically oriented sidewall 21 by numerous slanted or inclined bottom sections 33, 34, 35 or 36.

The slanted or beveled bottom sections 33, 34, 35, 36 provide a variation of the total surface of the molten evaporation material 12 inside the evaporation cavity 19. By raising or lowering the fluid level 15 in the region of the slanted or beveled bottom sections 33, 34, 35, 36 the size of the surface of the molten evaporation material 12 can be modified and changed, thereby allowing to modify, to adjust or to change the evaporation rate. Typically, the evaporation rate, at which molten evaporation material 12 transitions into evaporated material 14 is proportional to the size of the surface of the fluid level 15.

With the example as illustrated in Figs. 4-10, the first movable part 50 is movably arranged inside the vapor guiding part 40. The second movable part 16 may be arranged between the first movable part 50 and the vapor guiding part 40. It may be also provided inside the first movable part 50. In other examples the first movable part 50 may be movably disposed on or outside the vapor guiding part 40. Also, the second movable part 16 may be arranged outside the vapor guiding part 40 and/or outside the first movable part 50.

Moreover, the guiding aperture 44 is not limited to an elongated slit 46. In other examples it may be the guiding aperture 44 which is provided with a rectangular, a triangular, a rhombic, a round, an elliptic or oval shape whereas the first or second outlet apertures 54, 64 are provided with an elongated slit.

In some examples, the first movable part 50 and/or the second movable part 60 may be open ended. Hence, they may be void of a closed end wall 52, 53, 62, 63 provided that the and intermittent region between the vapor guiding part 40, the first movable part 50 and the second movable part 60 is sufficiently sealed, e.g. by way of one or several gaskets 47, 48. Specifically, a first gasket 47, e.g. in form of an annular shaped gasket, may be located around a circumference of the first movable part 50 longitudinally offset from a first longitudinal end of the first outlet aperture 54. A second gasket may be located around a circumference of the first movable part longitudinally offset from a second longitudinal end of the first outlet aperture 54. Likewise, a region between the first movable part 50 and the second movable part 60 can be sealed accordingly by way of additional gaskets (not illustrated).

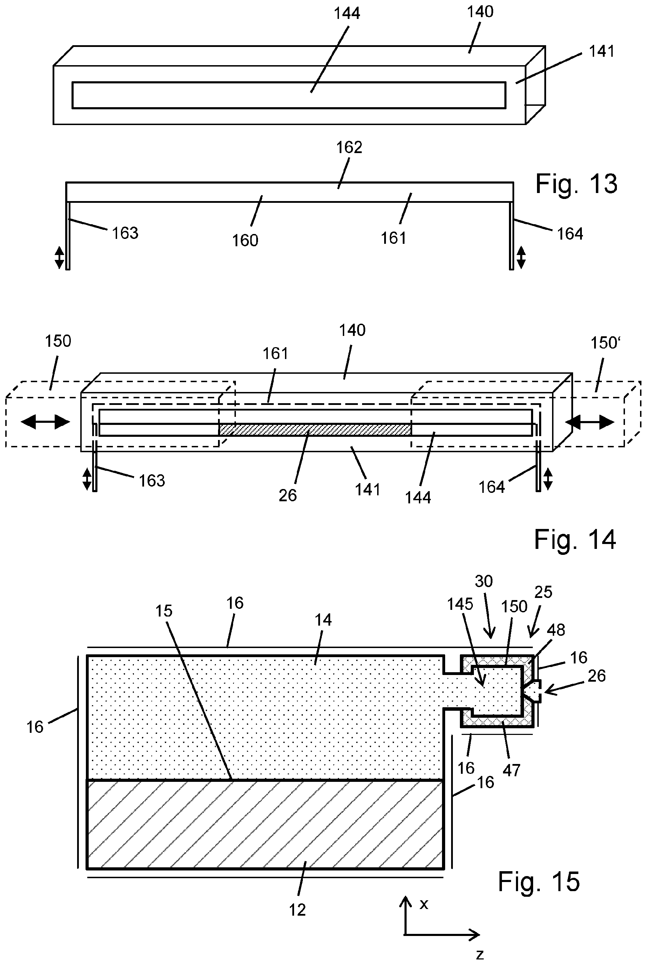

In the further example of Figs. 11-15 there is shown another solution for an aperture adjustment 130. Here, the vapor guiding part 140 is of cuboid shape. It comprises a sidewall 141 of quadratic or rectangular cross section. The sidewall 141 also comprises an elongated aperture 144 also implemented as an elongated slit 146. The elongated slit 146 comprises a oppositely located longitudinal ends 144a, 144b. The sidewall 141 is open towards the opposite longitudinal end. Similarly and as described with regard to the sidewall 41 also the sidewall 141 comprises an inlet aperture 145, which is only indicated in the cross-section of Fig. 15. Through the inlet aperture 145 vapor generated inside the evaporation cavity 19 is able to flow into the interior of the sidewall 141.

The aperture adjustment 130 and hence the outlet arrangement 24 provided by the vapor guiding part 140 is further provided with a first movable part 150. The first movable part comprises a sidewall 151 with an outside geometry that matches with an inside 138 of the sidewall 141. The first movable part 150 may be longitudinally slidably disposed inside the open ended sidewall 141 of the vapor guiding part 140. As becomes apparent from a comparison of Figs. 11 and 12 the first movable part 150 may be slidably supported or slidably inserted into a receptacle 142 formed by or at a longitudinal end of the sidewall 141. The first movable part 150 comprises a closed end wall 153, which when suitably mounted inside the sidewall 141 and hence inside the receptacle 142 effectively closes the vapor guiding part 140 towards the respective longitudinal end. Accordingly, the movable part 150 comprises a body 154, which forms a movable closure for the hollow vapor guiding part 140 towards a first longitudinal end of the vapor guiding part 140.

The first movable part 150 is slidably movable relative to the sidewall 141, thereby obstructing a larger or lesser portion of the aperture 144. The first movable part 150 may be also provided with a closed end wall 152 opposite the end wall 153. It may further comprise a top 158 and a bottom 154 side correspondingly or complementary shaped to a top side 148 and a bottom 147 of the sidewall 141 of the vapor guiding part 140.

The first movable part 150 may be implemented as a slider, which is slidably disposed inside the vapor guiding part 140. Here, the outside surface or outer cross-section of the first movable part 150 matches with an inside diameter or inside cross-section of the vapor guiding part 140, thus allowing to move the first movable part along a longitudinal extent, hence along a first direction (y) relative to the vapor guiding part 140. The sidewall 151 of the first movable part 150 at least partially obstructs the aperture 144 of the sidewall 141, thereby effectively increasing or decreasing the longitudinal extent of the resulting evaporation aperture 26 formed by the aperture 144 in the sidewall 141.

In other examples the first movable part 150 may be open ended at its longitudinal end facing towards the interior of the vapor guiding part 140. It may be void of the end wall 153 but may comprise a closed end wall 152. Here, an inside of the sidewall 151 may be sized to receive an outside of the sidewall 141. This way, the movable part 150 may be slidably supported on the outside of the sidewall 141 of the vapor guiding part 140. The sidewall 151 of the first movable part 150 may be a closed structure which is impenetrable for the evaporated material 14. In this way and by sliding the first movable part 150 relative to the vapor guiding part 140 an effective longitudinal extent of the aperture 144 can be modified and adjusted accordingly.

As further illustrated in Fig. 11 and 12 there may be provided a further first movable part 150'. The further first movable part 150' may be slidably provided at the opposite longitudinal end and hence in a second receptacle 143 of the vapor guiding part 140. It may serve to at least partially obstruct the opposite longitudinal end 144b of the elongated aperture 144 in the sidewall 141 of the vapor guiding part 140. The further first movable part 150' may be identically shaped to the first movable part 150. Insofar, all features, effects and benefits as described above in connection to the first movable part 150 equally apply to the further first movable part 150'.

Also, and in another example the further first movable part 150' may comprise a hollow shape and may be void of an end wall 152. It may be closed at an oppositely located end wall 153. Here, an inside or inner cross-section of the hollow sidewall 151 may be sized and configured to receive an outside surface or outside cross-section of the elongated vapor guiding part 140. In either way, the first movable part 150, 150' can be slidably displaced relative to the vapor guiding part 140, thereby allowing to modify the longitudinal extent of the resulting evaporation aperture 26, which is the non-obstructed part of the elongated aperture 144, that is not obstructed by the sidewall or sidewalls 151 of the first movable part 150 and the further first movable part 150'.

Of course, there may be also provided a gasket between the sidewall 141 and the sidewall(s) 151 in order to prevent an uncontrolled escape or release of evaporation material 14 from the evaporation cavity 19.

The first movable part of 150 and the further first movable part 150' may be movable independent of one another and relative to the vapor guiding part 140. The position of the first movable part 150 relative to the vapor guiding part 140 may determine the geometry or extend of the evaporated evaporation material 14 released from the outlet arrangement 24. The position of the first movable part 150 relative to the vapor guiding part 140 may thus determine a first edge or end of the vapor expansion as seen along the first direction of (y), e.g. perpendicular to the substrate transport direction 9.

The position of the further first movable part 150' relative to the vapor guiding part 140 may determine the position or geometric expansion of the evaporated material 14 in the opposite direction (-y).

Hence, by individually controlling and modifying or adjusting the position of the first movable part 150 and the position of the further first movable part 150' relative to the vapor guiding part 140 the size, i.e. the longitudinal extent of the resulting evaporation aperture 26 as well as the position of the evaporation aperture 26 along the first direction (y) relative to the evaporation crucible 20 can be adjusted in order to precisely match with the position and/or transverse width of the movable substrate 2.

As further illustrated in Figs. 13 and 14 the evaporator 10 and in particular the outlet arrangement 24 of the aperture adjustment 30 may be provided with a second movable part 160. The second movable part 160 may comprise a shutter 161 with a screen 162 which is impenetrable by the evaporated evaporation material 14. The shutter 161 may be provided with at least one handle 163, 164, by way of which the shutter 161 can be moved along a second direction (x). The second direction (x) may be perpendicular to the first direction (y). It may extend substantially parallel to the substrate transport direction 9. By moving the shutter 161 and hence its impenetrable screen section 162 along the second direction (x) the width of the evaporation aperture 26 can be modified along this second direction (x).

Hence, moving of the second movable part 160 along the second direction (x) provides a size adjustment of the evaporation aperture 26 with regard to the second direction (x).

A movement of the first movable part 150 or further first movable part 150' provides a modification or adjustment of the position and/or of the longitudinal extent of the evaporation aperture 26 along the first direction (y).

Of course, the second movable part 160 may comprise a sidewall, e.g. provided by the screen section 162. The sidewall or screen section 162 may be provided with an elongated aperture, in a similar way as described with respect to the second movable part 60 as shown in Fig. 8. Here, and by modifying the degree of overlapping or obstruction an aperture in the shutter 161 with the aperture 144 as provided in the sidewall 141 there can be provided a respective size adjustment of the resulting evaporation aperture 26.

A gasket 47, 48 between an outside surface of the first movable part 150, 150' and the inside of the sidewall 151 of the vapor guiding part 140 is schematically illustrated in Fig. 15. Typically, the gasket is provided at or near the end walls 152, 153 facing inwardly into the interior of the sidewall 141, which end walls 152, 153 serve to obstruct or to delimit the aperture 144 in the sidewall 141 of the vapor guiding part 140.

In Fig. 17 there is further illustrated another example of a bottom 22 of the evaporation crucible 20. Here, the bottom 22 may be somewhat identically shape to the bottom 22 as shown in Fig. 16. However, upper ends of the slanted or tilted bottom sections 33, 34, 35, 36, which are arranged in a rectangular funnel-shaped fashion, transition into laterally outwardly extending intermediate sidewall sections 72, which extend rather steep compared to the slanted bottom sections 33, 34, 34, 36. Upper ends of the sidewall section 72 then merge into further upper sidewall section 73, 74, 75, 76, which extend at shallow angle relative to the sidewall sections 72. Upper ends of the sidewall section 73, 74, 75, 76 then extend into an upright or vertically oriented sidewall 21 of the evaporation crucible 20.

The region of the intermediate sidewall sections 72 forms a kind of a sump section with a rather steep lateral enclosure. When the fluid level 15 is in the region of the intermediate sidewall sections 72, raising and lowering of the fluid level 15 has a rather limited effect on a variation of the evaporation rate. When the fluid level 15 is in the region of the upper side wall sections 73, 74, 75, 76 a raising and lowering of the fluid level 15 comes along with a respective increase or decrease of the surface of the molten evaporation material 12 inside the evaporation crucible 20.

An increase of the fluid level 15 leads to a respective increase of the surface of the molten evaporation material which is accompanied by an increase of the evaporation rate without modifying the temperature of the evaporation crucible 20 or the temperature of the molten evaporation material 12. Lowering of the fluid level 15 in the region of the sidewall sections 73, 74, 74, 76 allows to reduce the total surface of the molten evaporation material 12 and thereby reducing the evaporation rate without modifying the temperature of the evaporator 10.

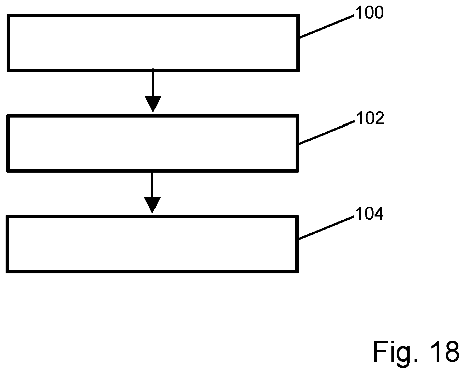

In the flowchart of Fig. 18 a method of coating a surface 3 of a substrate 2 is schematically illustrated. Here and in a first step 100 the substrate 2 is moved along a transport direction 9 through the evaporation chamber 8 as illustrated in Fig. 1. The moving substrate 2 may enter and exit the evaporation chamber 8 through one or numerous vacuum, which are not particularly illustrated here. In step 102 evaporated evaporation material 14 is directed onto the surface 3 of the moving substrate 2 and in step 104 the size of a flow-through cross-section of the aperture 26 of the outlet arrangement 24 of the evaporator 10 as described herein is adjusted to or in regard to a width of the substrate 2 perpendicular to the transport direction 9. The size adjustment can be obtained without moving the evaporator 10 or the outlet arrangement 24 relative to the evaporation chamber 20. Rather, there is provided an aperture adjustment 30, which allows in situ adjustment of the evaporation width of the evaporator 10, simply by moving the first movable part 50 150, the optional further first movable part 150' and/or the optional second movable part 60, 160 relative to the vapor guiding part 40, 140 as described above.

### Reference Numbers

- 1: coating arrangement
- 2: substrate
- 3: surface
- 4: side edge
- 5: evaporation arrangement
- 6: evaporation pump
- 7: coating width
- 8: evaporation chamber
- 9: transport direction
- 10: evaporator
- 11: chamber wall
- 12: molten material
- 13: interior
- 14: evaporated material
- 15: fluid level
- 16: heating
- 18: heating
- 19: cavity
- 20: evaporation crucible
- 21: sidewall
- 22: bottom
- 23: top
- 24: outlet arrangement
- 25: nozzle section
- 26: evaporation aperture
- 27: inlet
- 28: pipe
- 29: end section
- 30: aperture adjustment
- 32: bottom section
- 33: bottom section
- 34: bottom section
- 35: bottom section
- 36: bottom section
- 40: vapor guiding part
- 41: sidewall
- 42: end wall
- 43: end wall
- 44: guiding aperture
- 45: inlet aperture
- 46: slit
- 47: gasket
- 48: gasket
- 49: center axis
- 50: movable part
- 51: sidewall
- 52: end wall
- 53: end wall
- 54: outlet aperture
- 55: beveled section
- 56: beveled section
- 57: rhomb geometry
- 58: inlet aperture
- 59: rotation axis
- 60: movable part
- 61: sidewall
- 62: end wall
- 63: end wall
- 64: outlet aperture
- 65: edge
- 66: slit
- 67: edge
- 68: inlet aperture
- 69: rotation axis
- 72: sidewall section
- 73: sidewall section
- 74: sidewall section
- 75: sidewall section
- 76: sidewall section
- 130: aperture adjustment
- 138: inside
- 139: outside
- 140: vapor guiding part
- 141: sidewall
- 142: receptacle
- 143: receptacle
- 144: outlet aperture
- 145: inlet aperture
- 146: slit
- 147: bottom
- 148: top
- 149: sidewall
- 150: movable part
- 151: sidewall
- 152: end wall
- 153: end wall
- 154: body
- 157: bottom
- 158: top
- 159: sidewall
- 160: movable part
- 161: shutter
- 162: screen section
- 163: handle
- 164: handle

## Claims

1. An evaporator (10) for use inside an evaporation chamber (8) and configured to evaporate an evaporation material (12), the evaporator (10) comprising:
- an evaporation crucible (20) comprising an evaporation cavity (19) to contain evaporation material (14),
- an outlet arrangement (24) in flow connection with the evaporation cavity (19) and comprising an evaporation aperture (26) for evaporated evaporation material (14) to flow from the evaporation cavity (19) into the evaporation chamber (8), wherein the aperture (26) comprises a flow-through cross-section of variable and/or adjustable size.

2. The evaporator (10) according to claim 1, wherein the outlet arrangement (24) comprises a vapor guiding part (40; 140) with a sidewall (41; 141) comprising a guiding aperture (44; 144) extending through the sidewall (41; 141).

3. The evaporator (10) according to claim 2, wherein the outlet arrangement (24) comprises a first movable part (50; 150) moveable relative to the vapor guiding part (40; 140), wherein the first movable part (50, 150) comprising a movable sidewall (51; 151) to at least partially and variably or adjustably obstruct the guiding aperture (44, 144) of the vapor guiding part (40; 140).

4. The evaporator (10) according to claim 3, wherein the guiding aperture (44; 144) is an elongated aperture (44; 144) extending along a first direction (y) and wherein the first movable part (150) is movable relative to the vapor guiding part (140) along the first direction to vary a degree of obstruction of the guiding aperture (144) by the first movable part (150).

5. The evaporator (10) according to any one of the preceding claims 3 or 4, wherein the outlet arrangement (24) comprises a further first movable part (150') movably disposed on or inside the vapor guiding part (140) and comprising a movable sidewall (151') to at least partially obstruct the guiding aperture (144) of the vapor guiding part (140), wherein the first movable part (150) is movably disposed at or near a first longitudinal end (144a) of the guiding aperture (144) and wherein the further first movable part (150') is movably disposed at or near a second longitudinal end (144b) of the guiding aperture (144) opposite to the first longitudinal end (144a) of the guiding aperture (144).

6. The evaporator (10) according to any one of the claims 3-5, wherein the first movable part (50) comprises a first outlet aperture (54) in the movable sidewall (51) to at least partially overlap with the guiding aperture (44) of the vapor guiding part (40).

7. The evaporator (10) according to claim 6, wherein the first movable part (50) is movable relative to the vapor guiding part (40) to vary a degree of overlapping of the first outlet aperture (54) and the guiding aperture (44).

8. The evaporator (10) according to claim 3 to 7, wherein the sidewall (41) of the vapor guiding part (40) is of tubular shape and wherein the first movable part (50) is rotatable relative to the sidewall (41) with a longitudinal axis (49) of the sidewall (41) as an axis of rotation.

9. The evaporator (10) according to any one of the preceding claims 6-8, wherein one of the guiding aperture (44) and the first outlet aperture (54) comprises an elongated slit and wherein the other one of the guiding aperture (44) and the first outlet aperture (54) comprises one of a rectangular, triangular, rhombic, round, elliptic or oval shape.

10. The evaporator (10) according to any one of the preceding claims 2-9, wherein the outlet arrangement (24) comprises a second movable part (160) movable relative to the vapor guiding part (40; 140) and comprising a movable shutter (161) to at least partially and variably or adjustably obstruct the guiding aperture (44; 144) of the vapor guiding part (40; 140).

11. The evaporator (10) according to claim 10, wherein the second movable part (160) is movable relative to the vapor guiding part (140) along a second direction (z).

12. The evaporator (10) according to any one of the preceding claims 2-9, wherein the outlet arrangement (24) comprises a second movable part (60; 160) movable relative to the vapor guiding part (40; 140) and comprising a second outlet aperture (64) to at least partially and variably or adjustably overlap with the guiding aperture (44; 144).

13. A coating arrangement (1) for coating a surface (3) of a substrate (2) through vapor deposition, the coating arrangement (1) comprising:
- an evaporation chamber (8) to receive the substrate (2), and
- an evaporator (10) according to any one of the preceding claims in direct flow connection with an interior (13) of the evaporation chamber (8).

14. The coating arrangement (1) according to claim 13, wherein the substrate (2) comprises one a continuous band or strip of material and a sheet of material continuously moving relative to the evaporator (10) along a transport direction (9) and wherein the flow-through cross-section of the aperture (26) of the evaporator (10) is a variable and/or adjustable in size along a first direction (y) extending at a predefined angle relative to the transport direction (9).

15. A method of continuously coating a surface (3) of a movable substrate (2) inside an evaporation chamber (8) of a coating arrangement (1) according to claim 13 or 14, the method comprising the steps of:
- continuously moving the substrate (2) along a transport direction (9),
- directing evaporated evaporation material (14) onto the surface (3) of the moving substrate (2) and
- adjusting the size of a flow-through cross-section of the aperture (26) of the outlet arrangement (24) of the evaporator (10) to a width of the substrate (2) perpendicular to the transport direction (9).
